# EUROPEAN PATENT APPLICATION

(11) **EP 4 456 114 A1**
(43) Date of publication of application: **30.10.2024**
(21) Application number: 21926073.4
(22) Date of filing: 24.12.2021

(54) **DISPLAY PANEL, DISPLAY MODULE, AND MOBILE TERMINAL**

(30) Priority: 21.12.2021 CN 202111573343
(71) Applicant: Wuhan China Star Optoelectronics Semiconductor Display Technology Co., Ltd., Wuhan, Hubei 430079 (CN)
(72) Inventor: ZHOU, Wenjun, Wuhan, Hubei 430079 (CN)
(74) Representative: Murgitroyd & Company
(86) International application number: PCT/CN2021/141054
(87) International publication number: WO 2023/115504

(57) **Abstract**

The present application discloses a display panel, a display module and a mobile terminal. The display panel includes a substrate, a light emitting device layer and a color film layer. The substrate includes a first boundary close to the cutting surface of the display panel. In a top view direction of the display panel, and along a direction from the substrate to the color film layer in the display panel, a distance between a film boundary on a side of the film layer close to the cutting surface and the first boundary gradually increases, and an included angle between the cutting surface and the substrate is defined as an obtuse angle.

## Description

### BACKGROUND

### Field of invention

The present application relates to the display field, and particularly to a display panel, a display module and a mobile terminal.

### Description of Prior Art

Organic light-emitting diode (OLED) panels have the advantages of lightness and thinness, large viewing angles and power saving, and become the mainstream of future development.

In the existing OLED display panels, in order to reduce the thickness of the display panel, a depolarizer technology can be used to manufacture the OLED panels. That is, an existing polarizer can be replaced by a color resistance layer and a black matrix layer. During panel cutting, because the black matrix on the periphery of the display panel needs to be cut by a laser, a high temperature of the laser will lead to the carbonization of the black matrix, and the carbonized carbon chips may remain in an edge gap of the display panel, affecting the cleanliness of the display panel.

Therefore, a display panel is urgently needed to solve the above technical problems.

### SUMMARY

The present application provides a display panel, a display module and a mobile terminal, so as to solve the technical problem of carbon chips in the edge gap of the existing display panels.

The present application provides a display panel comprising:
a substrate, comprising a first boundary close to a cutting surface of the display panel;
a light emitting device layer arranged on the substrate; and
a color film layer arranged on the light emitting device layer;
wherein, in a top view direction of the display panel, and along a direction from the substrate to the color film layer in the display panel, a distance between a film boundary on a side of the film layer close to the cutting surface and the first boundary gradually increases, and an included angle between the cutting surface and the substrate is defined as an obtuse angle.

In some embodiments of the present application, the included angle between the cutting surface and the substrate ranges from 100° to 120°.

In some embodiments of the present application, the display panel further comprises a plurality of organic layers, and one side of at least one of the organic layers close to the cutting surface is provided with a black material.

In some embodiments of the present application, in a plurality of organic layers of the display panel, the mass of the black material on the organic layer close to the substrate is greater than that on the organic layer away from the substrate.

In some embodiments of the present application, the color film layer comprises a light shielding layer and a plurality of color resistance units embedded in the light shielding layer, and the light shielding layer comprises a first light shielding part arranged close to the cutting surface of the display panel.

In some embodiments of the present application, the first light shading part comprises a second boundary close to the cutting surface, and a distance from the second boundary to the cutting surface is greater than or equal to 0 and less than or equal to 150 microns.

In some embodiments of the present application, when the distance from the second boundary to the cutting surface is equal to 0, the second boundary coincides with the cutting surface.

In some embodiments of the present application, the light shielding layer further comprises a second light shielding part away from the cutting surface, and a thickness of the second light shielding part is greater than that of the first light shielding part.

In some embodiments of the present application, when the second boundary is arranged away from the cutting surface, an area of the first shading part close to the cutting surface is provided with a first notch, and the first notch faces the cutting surface.

In some embodiments of the present application, the display panel further comprises a first flat layer arranged on the color film layer, the first flat layer covers the color film layer, and a thickness of the first flat layer is less than or equal to a thickness of the second shading part.

The present application also provides a display module. The display module comprises a display panel and a cover layer arranged on the display panel,
wherein an orthographic projection of the display panel on the cover layer is located in the cover layer; wherein the display panel comprises:
The present application also provides a mobile terminal. The mobile terminal comprises a terminal body and a display module, and the terminal body and the display module are integrated.

By arranging the cutting surface of the edge of the display panel as an inclined plane away from the display panel, the application makes the carbon chips generated during the cutting process of the display panel accumulate on the side close to the substrate, avoids the residue of carbon chips on the side close to the substrate, and improves the cleanliness of the product.

### BRIEF DESCRIPTION OF DRAWINGS

FIG. 1 is a cross-sectional view of an existing display panel.
FIG. 2 is an enlarged view of an abnormal area of an existing display panel.
FIG. 3 is a schematic diagram of the cutting of the display panel of the present application.
FIG. 4 is a first cross-sectional view of section AA in FIG. 3.
FIG. 5 is a detailed structure diagram of part of the film layers in FIG. 4.
FIG. 6 is a schematic diagram of a Gaussian spot of a laser.
FIG. 7 is a first cross-sectional view of section AA in FIG. 3 before cutting.
FIG. 8 is a second cross-sectional view of section AA in FIG. 3.
FIG. 9 is a third cross-sectional view of section AA in FIG. 3.
FIG. 10 is a second cross-sectional view of section AA in FIG. 3 before cutting.
FIG. 11 is a structure schematic diagram of a display module of the present application.

### DETAILED DESCRIPTION OF PREFERRED EMBODIMENTS

In the following, the technical scheme in the embodiment of the present application will be described clearly and completely in combination with the drawings. It should be understood that the specific embodiments described herein are only used to explain the present application and are not used to limit the present application.

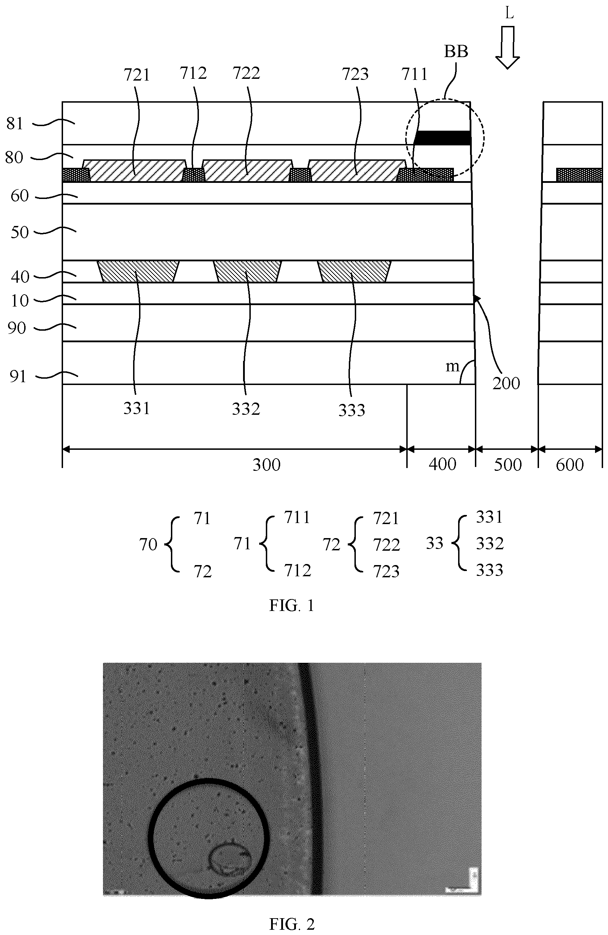

Referring to FIG. 1, FIG. 1 is a cross-sectional view of an existing display panel. In an existing OLED display panels, in order to reduce the thickness of the display panel, a depolarizer technology can be used to manufacture the OLED panel. That is, an existing polarizer is replaced by a color resistance layer and a black matrix layer. In order to ensure the flatness of the product, a first flat layer is usually coated on a color film layer, and a protective layer is bonded on the first flat layer to protect the film layer. During panel cutting, a temperature of the laser L may carbonize the black shading layer 71 close to the cutting surface 200. At the same time, due to the small peeling force between the first protective layer 81 and the first flat layer 80, the carbonized black material enters the gap between the first protective layer 81 and the first flat layer 80, affecting the cleanliness of the display panel. Referring to FIG. 2 for details, a structure of a circle area in the figure is the black inhomogeneity of area BB in FIG. 1. Therefore, the present application proposes a display panel to solve the above technical problem.

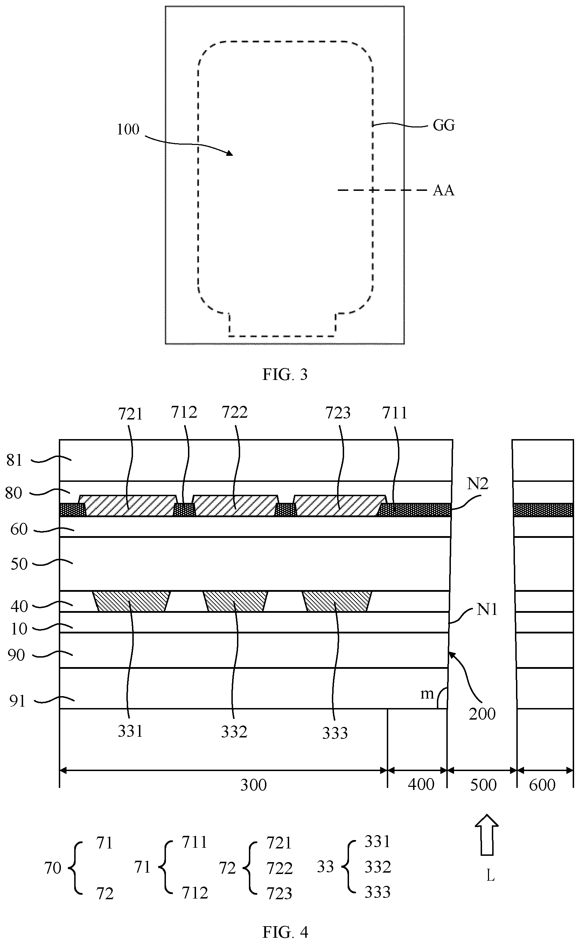

Referring to FIGs. 3 to 11, the present application provides a display panel 100 that includes a substrate 10, a light emitting device layer 30, and a color film layer 70. The light emitting device layer 30 is arranged on the substrate 10. The color film layer 70 is arranged on the light emitting device layer 30. The substrate 10 includes a first boundary N1 close to a cutting surface 200 of the display panel 100.

In the present embodiment, in a top view direction of the display panel 200, and along a direction from the substrate 10 to the color film layer 70 in the display panel 100, a distance between the film boundary on a side of the film layer close to the cutting surface 200 and the first boundary N1 gradually increases. An included angle m between the cutting surface 200 and the substrate 10 is an obtuse angle.

It should be noted that the included angle m between the cutting surface 200 and the substrate 10 is an actual included angle formed between the cutting surface 200 and the substrate 10 in FIG. 4. The cutting surface 200 is inclined to the side away from the display panel 100.

In the present embodiment, the included angle m between the cutting surface 200 and the substrate 10 ranges from 100° to 120°.

By arranging the cutting surface 200 of the edge of the display panel 100 as an inclined plane away from the display panel 100, the present application makes the carbon chips generated in the cutting process of the display panel 100 accumulate on the side close to the substrate 10, avoids the residue of carbon chips on the side close to the substrate 10, and improves the cleanliness of the product.

The technical scheme of the present application is described in combination with specific embodiments.

Referring to FIG. 3, the dotted line in FIG. 3 is a cutting track GG of the target panel. A shape surrounded by the cutting track GG is the peripheral shape of the display panel 100.

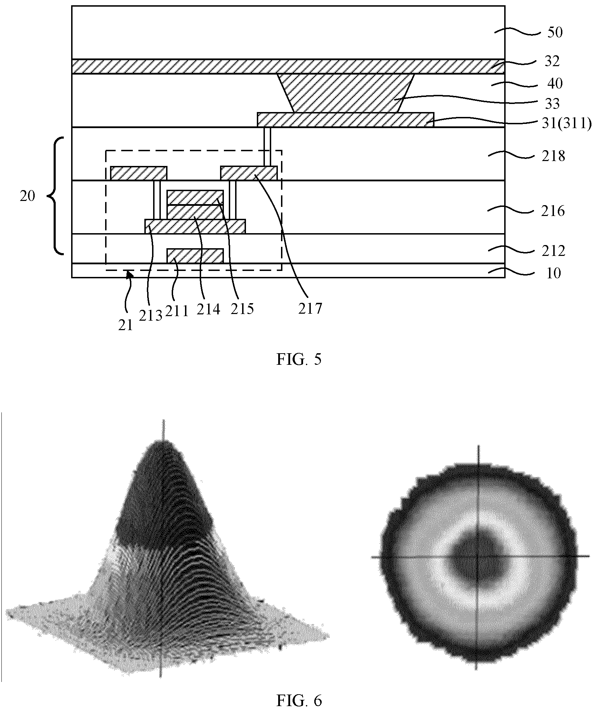

Referring to FIG. 4 and FIG. 5, FIG. 4 is a first cross-sectional view of section AA in FIG. 3. FIG. 5 is a detailed structure diagram of part of the film layers in FIG. 4.

The display panel 100 can include a thin film transistor array layer 20 arranged on the substrate 10, a pixel definition layer 40 arranged on the thin film transistor array layer 20, a light emitting device layer 30 arranged on the same layer as the pixel definition layer 40, a packaging layer 50 arranged on the pixel definition layer 40, a touch layer 60 arranged on the packaging layer 50, a color film layer 70 arranged on the touch layer 60, a first flat layer 80 arranged on the color film layer 70, and a first protective layer 81 arranged on the first flat layer 80.

In the present embodiment, the material of the substrate 10 can be a material such as glass, quartz or polyimide.

In the present embodiment, referring to FIG. 5, the thin film transistor array layer 20 can include a plurality of thin film transistors 21, which may be etching barrier type, back channel etching type, or divided into bottom gate thin film transistor, top gate thin film transistor and other structures according to a position of the gate and the active layer. For example, the thin film transistor 21 shown in FIG. 5 is a top gate thin film transistor. The thin film transistor 21 can include a light shielding metal layer 211 arranged on the substrate 10, a buffer layer 212 arranged on the light shielding metal layer 211, an active layer 213 arranged on the buffer layer 212, a gate insulating layer 214 arranged on the active layer 213, a gate layer 215 arranged on the gate insulating layer 214, an interlayer insulating layer 216 arranged on the gate layer 215, a source drain layer 217 arranged on the interlayer insulating layer 216, and a second flat layer 218 arranged on the source drain layer 217.

In the present embodiment, referring to FIG. 5, the display panel 100 can also include an anode layer 31 arranged on the second flat layer 218, a light emitting layer 33 arranged on the anode layer 31, and a cathode layer 32 arranged on the light emitting layer 33. The anode layer 31 includes a plurality of anodes 311. The pixel definition layer 40 includes a plurality of pixel openings corresponding to the plurality of anodes 311 one-to-one. Each pixel opening correspondingly exposes the upper surface of one anode 311. The light emitting layer 33 can include a plurality of light emitting pixels corresponding to the plurality of anodes 311one-to-one.

In the present embodiment, referring to FIG. 4, the encapsulation layer 50 covers the pixel definition layer 40, and continuously covers a plurality of pixel openings and a plurality of light emitting pixels. The packaging layer 50 can include at least a first inorganic packaging layer, a first organic packaging layer and a second inorganic packaging layer stacked on the pixel definition layer 40.

In the present embodiment, referring to FIG 4, the touch layer 60 includes a first touch metal layer and a second touch metal layer arranged on the packaging layer 50, and an insulating layer arranged between the first touch metal layer and the second touch metal layer.

In the present embodiment, the touch layer 60 provided by the embodiment of the present application can be mutual compatible or self-contained.

In the present embodiment, referring to FIG. 4, the color film layer 70 can be arranged on the touch layer 60. The color film layer 70 can include a light shielding layer 71 and a plurality of color blocking units 72 of different colors embedded in the light shielding layer 71. One color blocking unit 72 corresponds to a light emitting pixel. The color of the color blocking unit 72 is the same as the light emitted by the corresponding light emitting pixel.

In the present embodiment, referring to FIG. 4, the light emitting layer 33 includes a first light emitting pixel 331 emitting a first color, a second light emitting pixel 332 emitting a second color, and a third light emitting pixel 333 emitting a third color. The color film layer 70 includes a first color blocking unit 721, a second color blocking unit 722, and a third color blocking unit 723. The first light emitting pixel 331 corresponds to the first color blocking unit 721. The second light emitting pixel 332 corresponds to the second color blocking unit 722. The third light emitting pixel 333 corresponds to the third color blocking unit 723.

In the present embodiment, the first light emitting pixel 331 is a red light emitting pixel. The second light emitting pixel 332 is a green light emitting pixel. The third light emitting pixel 333 is a blue light emitting pixel. The first color resistance unit 721 is a red color resistance. The second color resistance unit 722 is a green color resistance. The third color resistance unit 723 is a blue color resistance.

In the present embodiment, the orthographic projection of the first light emitting pixel 331 on the first color blocking unit 721 is located in the first color blocking unit 721. The orthographic projection of the second light emitting pixel 332 on the second color blocking unit 722 is located in the second color blocking unit 722. The orthographic projection of the third light emitting pixel 333 on the third color blocking unit 723 is located in the third color blocking unit 723.

In the present embodiment, a material of the first flat layer 80 can be provided with the same organic material as the second flat layer 218.

In the present embodiment, a material of the first protective layer 81 can be a flexible material such as polyethylene terephthalate.

In the present embodiment, the display panel 100 can also include a backplane 90 and a second protective layer 91 bonded with the backplane 90. The backplane 90 is arranged on a side of the substrate 10 away from the light output direction, and the second protective layer 91 is arranged on a side of the backplane 90 away from the light output direction.

In the present embodiment, a function of the second protective layer 91 is the same as that of the first protective layer 81. A material of the second protective layer 91 can be the same as that of the first protective layer 81.

In the present embodiment, a peeling force between the first protective layer 81 and the first flat layer 80 is 1 to 4 g/inch. And a peeling force between the second protective layer 91 and the backplane 90 is 45 to 55 g/inch.

In the present embodiment, the first protective layer 81 and the second protective layer 91 are intermediate products in a manufacturing process of the display panel 100 and exist only in the intermediate process of the manufacturing process to protect the first flat layer 80 and other film layer structures below. In a final product, the first protective layer 81 and the second protective layer 91 will be stripped.

Referring to FIG 4, the display panel 100 can include a display area 300 and a non-display area 400 located on the periphery of the display area 300. At the same time, a cutting area 500 and a cutting product 600 left by cutting are arranged on the side away from the non-display area 400.

In the cutting process of the display panel 100, the laser L needs to be used to cut the display panel 100. For example, in the structure in FIG. 4, the product on the left side of the cutting area 500 is a target product, and the product on the right side of the cutting area 500 is a useless cutting product 600.

In the present embodiment, since the spot of the laser L is a Gaussian spot, as shown in FIG. 6, the laser L has the characteristics of high intermediate energy and decreasing surrounding energy in turn. Therefore, the film profile cut by the laser L may present a triangular shape.

In the present embodiment, since the high temperature action of the laser L will carbonize the organic material, and the peeling force between the first protective layer 81 and the first flat layer 80 is less than that between the second protective layer 91 and the backplane 90, if the cutting is started from the light output direction side of the display panel 100, the carbon chips generated by the laser L may remain between the first protective layer 81 and the first flat layer 80. Referring to FIG. 4, in the present application, the laser L is used to cut from the backlight side of the display panel 100, and the carbon chips generated by the laser L are accumulated to the light outlet side away from the display panel 100 by the action of gravity. However, due to the large peeling force between the second protective layer 91 and the backplane 90, the carbon chips can only remain on the surface of the cutting surface 200 without entering between the second protective layer 91 and the backplane 90. And part of the residual carbon chips will be removed by gravity or subsequent edge cleaning.

In the present embodiment, the film section cut by laser L is in a regular triangular shape.

In the display panel 100 of the present application, referring to FIG. 4, along a direction from the substrate 10 to the color film layer 70 in the display panel 100, a distance between the film boundary on a side of the film layer close to the cutting surface 200 and the first boundary N1 gradually increases. That is, in the direction from the substrate 10 to the color film layer 70, without considering the patterning of each film layer, an outer contour area of the film layer in the display panel 100 gradually increases.

In the present embodiment, in addition to the characteristics of the laser L itself, the film layers close to the light output direction have more organic materials, such as the first flat layer 80, the color film layer 70, the pixel definition layer 40, etc., and the high temperature effect of the laser L will carbonize the organic material and produce carbon chips affecting the cleanliness of the panel. Therefore, the outer contour area of the film layer close to the light exit direction side can be greater than that away from the light exit direction side. That is, the distance between the boundary of the film close to the light exit direction side and the first boundary N1 is less than that between the boundary of the film away from the light exit direction side and the first boundary N1. That is, the film layer away from the light outlet side is cut first, which not only has a large opening, but also makes the generated carbon chips fall from the bottom opening directly by gravity, so as to avoid the accumulation of carbon chips. And for the scheme of cutting from the light outlet side, since the film layer near the light outlet side has more organic materials, the generated carbon chips will fall from the light outlet side with the whole cutting process, resulting in more carbon chips remaining on the surface of the film. Therefore, the technical scheme of the present application can fundamentally solve the problem of carbon chips residue.

In the cutting process, as the laser L moves along the luminous direction of the display panel 100, the cutting surface 200 of the display panel 100 is an inclined surface with a certain inclination angle due to the influence of the characteristics of the laser L.

In the present embodiment, the included angle m between the cutting surface 200 and the substrate 10 may range from 100° to 120°. And the included angle m can be the actual included angle between the cutting surface 200 and the substrate 10. Due to the characteristics of the laser L, the included angle m between the cutting surface 200 and the substrate 10 can be close to 90° by controlling the energy of the laser L. At present, due to the limitation of the process, it can only reach 120°. And the included angle between the side of the display panel 100 and the substrate 10 can be close to 90° by edging or other processing.

In the display panel 100 of the present application, the display panel 100 further comprises a plurality of organic layers, and one side of at least one of the organic layers close to the cutting surface is provided with a black material.

In the present embodiment, since the display panel 100 includes organic layers such as the first flat layer 80, the color film layer 70, the organic packaging layer, and the pixel definition layer 40, the high temperature of the laser L may carbonize the organic material. Therefore, after cutting, the carbonized carbon chips may remain in an edge area of the film layer. And the carbon chips cannot be completely eliminated in a subsequent edge grinding process. Therefore, it may remain on the cutting surface 200. At the same time, the carbonized organic layer is attached to the side of the organic layer, which can protect the organic materials in the display area 300, such as water and oxygen resistance.

In the present embodiment, the carbon chips produced will fall to the side away from the light emitting side of the display panel 100 by gravity. Therefore, more carbon chips may remain on the side away from the light emitting direction of the display panel 100. That is, the quality of the black material on the organic layer on the side close to the substrate 10 is greater than the quality of the black material on the organic layer on the side far from the substrate.

In the display panel 100 of the present application, the light shielding layer 71 includes a first light shielding part 711 close to the cutting surface 200 of the display panel 100. The first light shielding part 711 includes a second boundary N2 close to the cutting surface 200. And a distance between the second boundary N2 and the cutting surface 200 is greater than or equal to 0 and less than or equal to 150 microns.

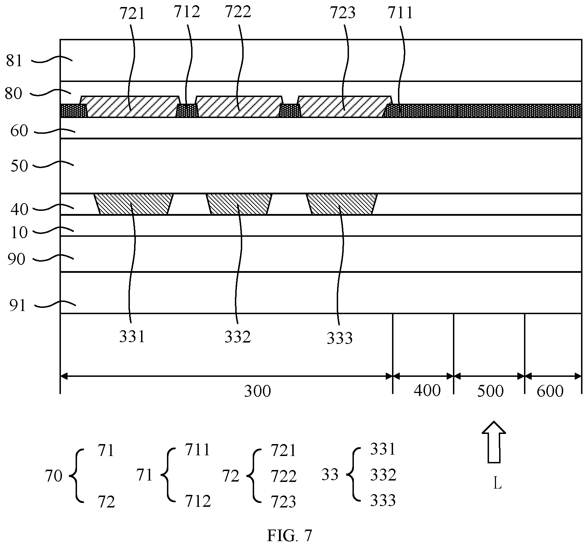

Referring to FIG. 4, when the distance from the second boundary N2 to the cutting surface is equal to 0, the second boundary N2 coincides with the cutting surface. Please refer to FIG 7. FIG. 7 is a first cross-sectional view of section AA in FIG. 3 before cutting. The first shading part 711 extends from the non-display area 400 to the cutting area 500. The laser L is in direct contact with the first shading part 711 during cutting, and the black carbon chips generated by the two will fall from the bottom of the display panel 100 with the action of gravity.

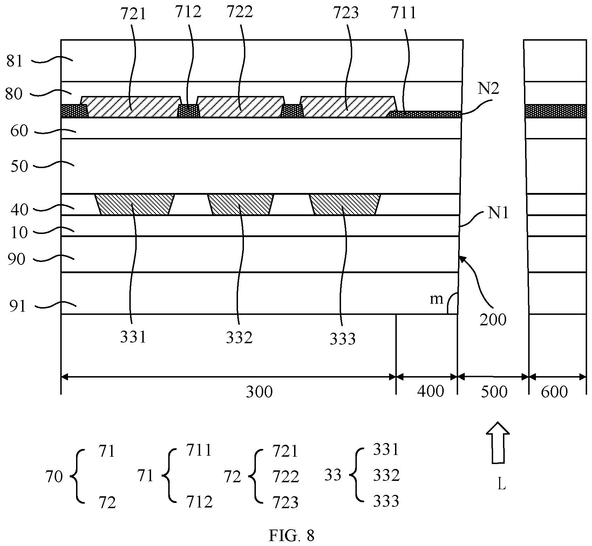

In the display panel 100 of the present application, referring to FIG. 8, the light shielding layer 71 also includes a second light shielding part 712 away from the cutting surface 200. A thickness of the second light shielding part 712 can be greater than that of the first light shielding part 711.

In the present embodiment, the light shielding layer 71 includes a second light shielding part 712 arranged in the display area 300 and a first light shielding part 711 arranged in the non-display area 400. Since the first light shielding part 711 is arranged close to the cutting surface 200, that is, when the display panel 100 is cut, the distance between the edge of the first light shielding part 711 and the laser L with higher temperature is small. There is a possibility that the laser L carbonizes the boundary of the first light shielding part 711. In the present application, by reducing the thickness of the first light shielding part 711, the generation of carbon chips can be reduced when the first light shielding part 711 is carbonized.

On the basis of FIG. 4, since the high temperature of the laser L has a certain carbonization effect on the organic material, the shading material that may carbonize is separated from the cutting area 500 in the present application.

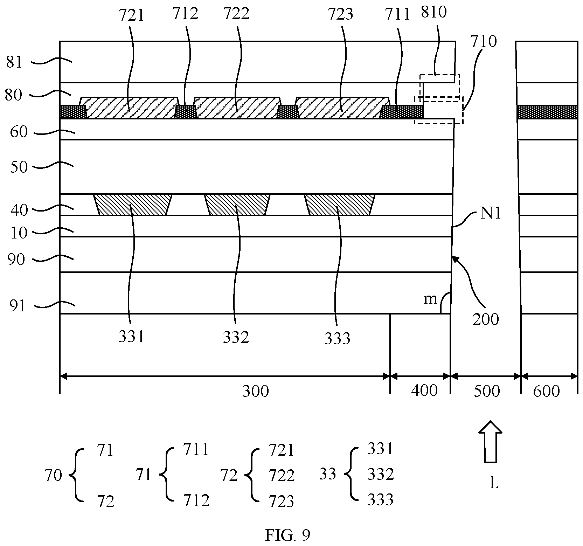

In the display panel 100 of the present application, please refer to FIG. 9. The display panel 100 also includes a first flat layer 80 arranged on the color film layer 70. The first flat layer 80 covers the color film layer 70. The first flat layer 80 can cover the first light shielding part 711 and extend to the cutting surface 200. And the second boundary N2 of the first light shielding part is arranged away from the cutting surface.

In the present embodiment, the distance between the second boundary N2 and the cutting surface 200 is less than or equal to 150 microns.

Referring to FIG. 9, an area of the shading layer 71 close to the cutting surface 200 of the display panel 100 can also be provided with a first notch 710, which faces the cutting surface 200. At the same time, the area of the first flat layer 80 close to the cutting surface 200 is provided with a second notch 810, and the second notch 810 faces the cutting surface 200.

Referring to FIG. 9, since the thickness of the color resistance unit 72 and the light shielding layer 71 are inconsistent, the flatness of the color film layer 70 is low after completing the color film process, so it is necessary to arrange the first flat layer 80 on the color film layer 70. At the same time, since the first flat layer 80 is composed of organic materials, the material of the flat layer can also be carbonized to form black carbon chips during laser L cutting. Therefore, the side of the first flat layer 80 close to the cutting surface 200 cannot be provided with flat layer material.

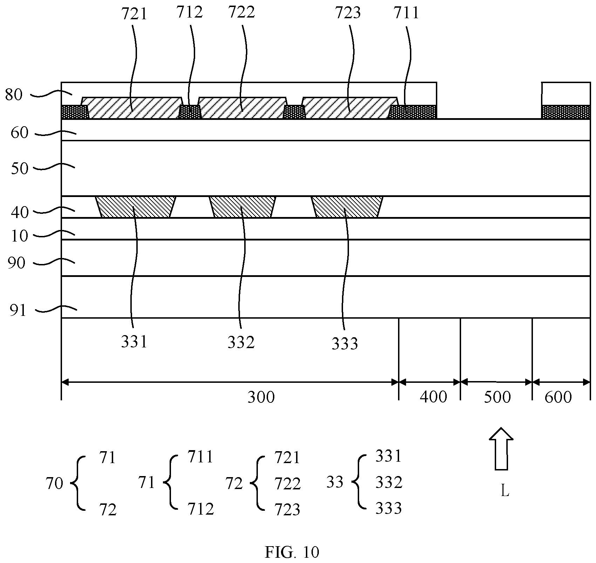

Referring to FIG. 10, FIG. 10 is a cross-sectional structure diagram of the cross-section AAof the display panel 100 of the present application before cutting. The light shielding layer 71 and the first flat layer 80 are both hollowed out on the side close to the cutting track GG. Since both the first flat layer 80 and the light shielding layer 71 can be composed of photoresist organic materials, the hollowed out area can be formed by a mask process, such as hollowing out the edges of the first flat layer 80 and the light shielding layer 71 through an exposure and development process, so that the boundary of the first flat layer 80 and the light shielding layer 71 is far away from the cutting track GG.

In the present embodiment, the second notch 810 corresponds to the first notch 710, and the area of the second notch 810 may be greater than or equal to the area of the first notch 710 to further increase the spacing between the boundary of the second notch 810 and the cutting surface 200.

In the present application, the second notch 810 is formed in the area of the first flat layer 80 close to the cutting surface 200, so that the boundary of the first flat layer 80 is far away from the cutting surface 200, even if the boundary of the first flat layer 80 is far away from the cutting track GG, so as to avoid the high temperature carbonization of the organic material constituting the first flat layer 80 by the laser L.

In the display panel 100 of the present application, referring to FIG. 4, a thickness of the first flat layer 80 may be less than or equal to a thickness of the second shading portion 712. Since the first flat layer 80 is arranged close to the cutting surface 200, in order to avoid the proportion of the first flat layer 80 carbonized by the laser L, the present application can reduce the thickness of the first flat layer 80.

In the present embodiment, since the first flat layer 80 is mainly used to smooth the surface of the uneven color film layer 70, the first flat layer 80 only needs to ensure the flatness of the surface of the color film layer 70. That is, the minimum thickness of the first flat layer 80 is the difference between a thickness of the color resistance unit 72 and the shading layer 71, to ensure that a thickness of the area corresponding to the light shielding layer 71 is the same as that of the area corresponding to the color resistance unit 72.

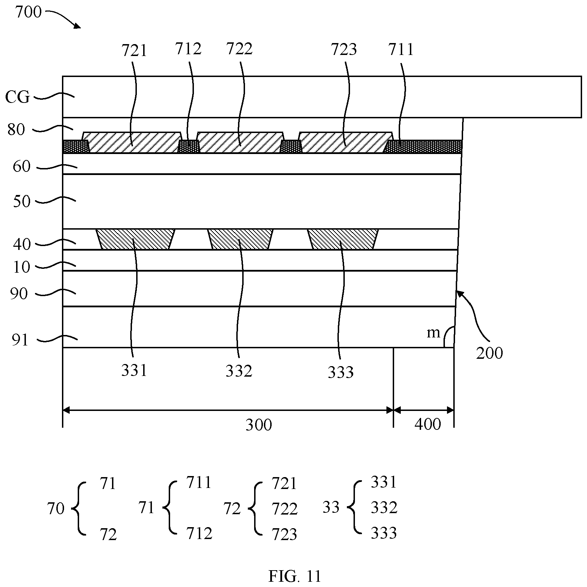

The present application also proposes a display module 700. Referring to FIG. 11, the display module 700 includes the display panel 100 and a cover layer CG located on the display panel 100. The orthographic projection of the display panel 100 on the cover layer CG is located in the cover layer CG.

In the present embodiment, compared with the structure in FIG. 4, the structure in FIG. 11 removes the first protective layer 81 and the second protective layer 91 in FIG. 4. At the same time, the display panel 100 can fit the first flat layer 80 and the cover layer CG through optical glue.

In the present embodiment, the cover layer CG mainly protects the lower panel structure. Therefore, in the top view direction of the display module 700, the outer boundary of the cover layer CG should be greater than that of the display panel 100.

The present application also provides a mobile terminal, which comprises a terminal body and the display module, and the terminal body and the display module are integrated. The terminal body can be a circuit board and other devices bound to the display module. The mobile terminal can include electronic devices such as mobile phones, televisions, laptops, etc.

It can be understood that for those skilled in the art, equivalent replacement or changes can be made according to the technical scheme of the application and its inventive concept, and all these changes or replacements should belong to the protection scope of the claims attached to the application.

## Claims

1. A display panel, comprising:
a substrate, comprising a first boundary close to a cutting surface of the display panel;
a light emitting device layer arranged on the substrate; and
a color film layer arranged on the light emitting device layer;
wherein, in a top view direction of the display panel, and along a direction from the substrate to the color film layer in the display panel, a distance between a film boundary on a side of the film layer close to the cutting surface and the first boundary gradually increases, and an included angle between the cutting surface and the substrate is defined as an obtuse angle.

2. The display panel of claim 1, wherein the included angle between the cutting surface and the substrate ranges from 100° to 120° .

3. The display panel of claim 1, wherein the display panel further comprises a plurality of organic layers, and one side of at least one of the organic layers close to the cutting surface is provided with a black material.

4. The display panel of claim 3, wherein in a plurality of organic layers of the display panel, the mass of the black material on the organic layer close to the substrate is greater than that on the organic layer away from the substrate.

5. The display panel of claim 1, wherein the color film layer comprises a light shielding layer and a plurality of color resistance units embedded in the light shielding layer, and the light shielding layer comprises a first light shielding part arranged close to the cutting surface of the display panel.

6. The display panel of claim 5, wherein the first light shading part comprises a second boundary close to the cutting surface, and a distance from the second boundary to the cutting surface is greater than or equal to 0 and less than or equal to 150 microns.

7. The display panel of claim 6, wherein when the distance from the second boundary to the cutting surface is equal to 0, the second boundary coincides with the cutting surface.

8. The display panel of claim 7, wherein the light shielding layer further comprises a second light shielding part away from the cutting surface, and a thickness of the second light shielding part is greater than that of the first light shielding part.

9. The display panel of claim 6, wherein when the second boundary is arranged away from the cutting surface, an area of the first shading part close to the cutting surface is provided with a first notch, and the first notch faces the cutting surface.

10. The display panel of claim 9, wherein the display panel further comprises a first flat layer arranged on the color film layer, the first flat layer covers the color film layer, and a thickness of the first flat layer is less than or equal to a thickness of the second shading part.

11. A display module, wherein the display module comprises a display panel and a cover layer arranged on the display panel, and an orthographic projection of the display panel on the cover layer is located in the cover layer; wherein the display panel comprises:
a substrate, comprising a first boundary close to a cutting surface of the display panel;
a light emitting device layer arranged on the substrate; and
a color film layer arranged on the light emitting device layer;
wherein, in a top view direction of the display panel, and along the direction from the substrate to the color film layer in the display panel, a distance between a film boundary on a side of the film layer close to the cutting surface and the first boundary gradually increases, and an included angle between the cutting surface and the substrate is defined as an obtuse angle.

12. The display module of claim 11, wherein the included angle between the cutting surface and the substrate ranges from 100° to 120°.

13. The display module of claim 11, wherein the display panel further comprises a plurality of organic layers, and one side of at least one of the organic layers close to the cutting surface is provided with a black material.

14. The display module of claim 13, wherein in a plurality of organic layers of the display panel, the mass of the black material on the organic layer close to the substrate side is greater than that on the organic layer away from the substrate side.

15. The display module of claim 11, wherein the color film layer comprises a light shielding layer and a plurality of color resistance units embedded in the light shielding layer, and the light shielding layer comprises a first light shielding part arranged close to the cutting surface of the display panel.

16. The display module of claim 15, wherein the first light shading part comprises a second boundary close to the cutting surface, and a distance from the second boundary to the cutting surface is greater than or equal to 0 and less than or equal to 150 microns.

17. The display module of claim 16, wherein when the distance from the second boundary to the cutting surface is equal to 0, the second boundary coincides with the cutting surface;
wherein, the light shielding layer further comprises a second light shielding part away from the cutting surface, and a thickness of the second light shielding part is greater than that of the first light shielding part.

18. The display module of claim 16, wherein when the second boundary is arranged away from the cutting surface, an area of the first shading part close to the cutting surface is provided with a first notch, and the first notch faces the cutting surface.

19. The display module of claim 18, wherein the display panel further comprises a first flat layer arranged on the color film layer, the first flat layer covers the color film layer, and a thickness of the first flat layer is less than or equal to a thickness of the second shading part.

20. A mobile terminal, wherein the mobile terminal comprises a terminal body and a display module according to claim 11, wherein the terminal body and the display module are integrated.
